# EUROPÄISCHE PATENTSCHRIFT

(11) **EP 3 504 152 B1**
(45) Veröffentlichungstag und Bekanntmachung des Hinweises auf die Patenterteilung: **24.02.2021**
(21) Anmeldenummer: 17746088.8
(22) Anmeldetag: 31.07.2017
(51) Int. Cl.: B81B 3/00, G01L 9/00, G01L 13/02, H04R 7/20

(54) **MIKROMECHANISCHES BAUTEIL MIT ZWEI MEMBRANEN UND HERSTELLUNGSVERFAHREN FÜR EIN MIKROMECHANISCHES BAUTEIL MIT ZWEI MEMBRANEN**
MICROMECHANICAL COMPONENT COMPRISING TWO MEMBRANES AND METHOD FOR PRODUCING A MICROMECHANICAL COMPONENT WITH TWO MEMBRANES
COMPOSANT MICROMÉCANIQUE À DEUX MEMBRANES ET PROCÉDÉ DE FABRICATION D'UN COMPOSANT MICROMÉCANIQUE À DEUX MEMBRANES

(30) Priorität: 29.08.2016 DE 102016216234
(43) Veröffentlichungstag der Anmeldung: 03.07.2019
(73) Patentinhaber: Robert Bosch GmbH, 70442 Stuttgart (DE)
(72) Erfinder: REINMUTH, Jochen, 72766 Reutlingen (DE); JAEGER, Stefan Thomas, 72127 Kusterdingen (DE); GRUTZECK, Helmut, 72127 Kusterdingen (DE)
(86) Internationale Anmeldenummer: PCT/EP2017/069265
(87) Internationale Veröffentlichungsnummer: WO 2018/041498

(56) Entgegenhaltungen:
- DE-A1-102014 214 525
- ROGGE B ET AL: "SOLDER-BONDED MICROMACHINED CAPACITVE PRESSURE SENSORS", OPTOMECHATRONIC MICRO/NANO DEVICES AND COMPONENTS III : 8 - 10 OCTOBER 2007, LAUSANNE, SWITZERLAND;PROCEEDINGS OF SPIE, SPIE, BELLINGHAM, WASH, Bd. 3514, 21. September 1998 (1998-09-21), Seiten 307-315, XP009024121, DOI: 10.1117/12.323902 ISBN: 978-1-62841-730-2
- DAS KAKALI ET AL: "Simulation and analytical study of MEMS based piezoresistive pressure sensor", 2016 INTERNATIONAL CONFERENCE ON MICROELECTRONICS, COMPUTING AND COMMUNICATIONS (MICROCOM), IEEE, 23. Januar 2016 (2016-01-23), Seiten 1-5, XP032930939, DOI: 10.1109/MICROCOM.2016.7522552 [gefunden am 2016-07-25]

## Beschreibung

Die Erfindung betrifft ein mikromechanisches Bauteil, ein Mikrofon und einen Drucksensor. Ebenso betrifft die Erfindung ein Herstellungsverfahren für ein mikromechanisches Bauteil.

### Stand der Technik

In der DE 10 2014 214 525 A1 sind mikro-elektromechanische Bauteile und Herstellungsverfahren zum Herstellen derselben beschrieben. In einer Ausführungsform der mikro-elektromechanischen Bauteile weist das mikro-elektromechanische Bauteil ein Halbleitersubstrat mit mindestens zwei aufgespannten Membranen auf, wobei die mindestens zwei Membranen je eine sich von einer ersten Seite in das Halbleitersubstrat erstreckende Aussparung so abdecken, dass die mindestens zwei Membranen mittels eines Druckunterschieds zwischen der ersten Seite und einer von der ersten Seite weg gerichteten zweiten Seite des Halbleitersubstrats verwölbbar sind. Zusätzlich ist mindestens eine Aktorelektrode so mit den mindestens zwei Membranen verbunden, dass die mindestens eine Aktorelektrode mittels einer Verwölbung der mindestens zwei Membranen in Bezug zu mindestens einer Statorelektrode verstellbar ist. Mittels einer Verstellbewegung der mindestens einen Aktorelektrode in Bezug zu der mindestens einen Statorelektrode soll der Druckunterschied zwischen der ersten Seite und der zweiten Seite des Halbleitersubstrats messbar sein.

### Offenbarung der Erfindung

Die Erfindung schafft ein mikromechanisches Bauteil mit den Merkmalen des Anspruchs 1, ein Mikrofon mit den Merkmalen des Anspruchs 10, einen Drucksensor mit den Merkmalen des Anspruchs 11 und ein Herstellungsverfahren für ein mikromechanisches Bauteil mit den Merkmalen des Anspruchs 12.

### Vorteile der Erfindung

Die vorliegende Erfindung schafft mikromechanische Bauteile, Mikrofone und Drucksensoren, deren Aktorelektroden (aufgrund ihrer Anbindung an die mindestens zwei Membranen mit jeweils den unterschiedlichen ersten und zweiten Ausdehnungen) mittels der Verwölbung der Membranen in jeweils eine stabile und gleichmäßige Bewegung versetzt werden. Diese stabile und gleichmäßige Bewegung der mindestens einen Aktorelektrode pro mikromechanischem Bauteil, Mikrofon oder Drucksensor eignet sich vorteilhaft zum Nachweisen, Verstärken und/oder Messen eines Druckunterschieds oder einer Schallwelle. Zusätzlich ist eine verbesserte Einhaltbarkeit der gewünschten stabilen und gleichmäßigen Bewegung der mindestens einen Aktorelektrode pro mikromechanischem Bauteil, Mikrofon oder Drucksensor gegenüber dem Stand der Technik mittels der vorliegenden Erfindung realisierbar.

Es wird auch darauf hingewiesen, dass die mindestens zwei Membranen des erfindungsgemäßen mikromechanischen Bauteils, Mikrofons oder Drucksensors aufgrund ihrer unterschiedlichen ersten und zweiten Ausnehmungen im Vergleich mit herkömmlichen runden oder quadratischen Vergleichsmembranen mit der gleichen Empfindlichkeit mit einer zweiten Ausdehnung ausgebildet werden können, welche kleiner als ein Durchmesser einer herkömmlichen runden Membran und kleiner als eine Seitenlänge einer herkömmlichen quadratischen Membran ist. Die vorliegende Erfindung kann somit auch dazu genutzt werden, eine Länge des mikromechanischen Bauteils, Mikrofons oder Drucksensors in der zweiten Raumrichtung zu reduzieren.

In einer vorteilhaften Ausführungsform des mikromechanisches Bauteils ist die erste Ausdehnung um zumindest einen Faktor von 2 größer als die zweite Ausdehnung. Eine derartige Ausbildung der mindestens zwei Membranen trägt zur zusätzlichen Stabilisierung der gewünschten gleichmäßigen Bewegung der mindestens einen Aktorelektrode des jeweiligen mikromechanischen Bauteils, in welche die mindestens eine Aktorelektrode mittels der Verwölbung der mindestens zwei Membranen versetzbar ist, bei. Außerdem kann die Form der mindestens zwei Membranen dieser Ausführungsform auch dazu genutzt werden, eine Läng des mikromechanischen Bauteils in der zweiten Raumrichtung zusätzlich zu reduzieren.

Vorzugsweise ist die mindestens eine Aktorelektrode mittels der Verwölbung der Membranen aus ihrer jeweiligen Ausgangsstellung entlang einer senkrecht zu der ersten Raumrichtung und senkrecht zu der zweiten Raumrichtung ausgerichteten dritten Raumrichtung verstellbar. Die mindestens eine Aktorelektrode kann somit mittels der Verwölbung der Membranen (entlang der dritten Raumrichtung) direkt auf mindestens eine (auf ihrer von den Membranen weg gerichteten Seite angeordnete) Statorelektrode zubewegt werden und/oder direkt von mindestens einer (auf ihrer zu den Membranen ausgerichteten Seite angeordneten) Statorelektrode weg bewegt werden. Dies kann zur Steigerung einer Nachweisgenauigkeit beim Nachweisen von Druckdifferenzen und/oder Messen von Druckdifferenzen beitragen.

Bevorzugter Weise weist das mikromechanische Bauteil genau eine erste Membran und eine zweite Membran als die mindestens zwei Membranen auf. Diese Ausführungsform des mikromechanischen Bauteils hat somit nicht mehr als zwei Membranen. Durch die Ausbildung der genau zwei Membranen mit der gleichen ersten Ausdehnung in der ersten Raumrichtung und der gleichen zweiten Ausdehnung in der zweiten Raumrichtung, wobei die erste Ausdehnung um zumindest einen Faktor von 1,25 größer als die zweite Ausdehnung ist, ermöglicht eine stabile, gleichmäßige und entlang der dritten Raumrichtung ausgerichtete Bewegung der mindestens einen Aktorelektrode. Die Ausbildung des mikromechanischen Bauteils mit nur den zwei Membranen erleichtert seine Minimierung und schafft gleichzeitig ein deutlich kompakteres Design dieser Ausführungsform des mikromechanischen Bauteils.

In einer besonders kompakten Ausführungsform weist das mikromechanische Bauteil genau eine einzige Aktorelektrode als die mindestens eine Aktorelektrode auf, wobei die erste Membran auf einer ersten Seite der Aktorelektrode und die zweite Membran auf einer von der ersten Seite weg gerichteten zweiten Seite der Aktorelektrode angeordnet sind. Vorzugsweise schneidet eine senkrecht zu der ersten Raumrichtung ausgerichtete Ebene die Aktorelektrode und die zwei Membranen mittig. Man kann diese Ausführungsform des mikromechanischen Bauteils auch damit umschreiben, dass die einzige Aktorelektrode zwischen den zwei ovalen oder länglichen Membranen angeordnet ist, wobei die jeweils "lange Seite" der ovalen oder länglichen Membranen "parallel" zu der einzigen Aktorelektrode ausgerichtet sind.

In einer vorteilhaften Weiterbildung sind die zwei Membranen mit je einem sich in die erste Raumrichtung erstreckenden Versteifungssteg ausgebildet. Die Ausbildung des je einen Versteifungsstegs an den zwei Membranen erleichtert eine Festlegung einer Membransteifigkeit/Membransensitivität auf einen gewünschten Wert, und trägt insbesondere dazu bei, dass Prozessschwankungen bei der Herstellung der mindestens zwei Membranen einen geringeren Einfluss auf die Membransteifigkeit/ Membransensitivität der zwei Membranen haben.

Vorzugsweise weist jeder der zwei Versteifungsstege einen ersten maximalen Abstand in der ersten Raumrichtung zu einem Rand seiner Membran auf, welcher um einen Faktor zwischen 1,1 und 2,5 größer ist als ein zweiter maximaler Abstand des gleichen Versteifungsstegs in der zweiten Raumrichtung zu dem Rand seiner Membran. Dies ermöglicht eine größere Flexibilität der zwei Membranen.

Als zusätzliche Weiterbildung kann mindestens einer der zwei Versteifungsstege über mindestens ein seine Membran teilweise überspannendes Federelement mit der Trägerstruktur verbunden sein. Über das mindestens eine Federelement kann mindestens eine Leiterbahn von der Trägerstruktur zu der Aktorelektrode verlaufen.

Die vorausgehend beschriebenen Vorteile sind auch bei einem Mikrofon mit einem entsprechenden mikromechanischen Bauteil gewährleistet.

Auch ein Drucksensor mit einem derartigen mikromechanischen Bauteil weist die oben beschriebenen Vorteile auf.

Die oben beschriebenen Vorteile sind auch durch ein Ausführen eines korrespondierenden Herstellungsverfahrens für ein mikromechanisches Bauteil realisierbar. Es wird darauf hingewiesen, dass das Herstellungsverfahren gemäß den oben erläuterten Ausführungsformen des mikromechanischen Bauteils weiterbildbar ist.

### Kurze Beschreibung der Zeichnungen

Weitere Merkmale und Vorteile der vorliegenden Erfindung werden nachfolgend anhand der Figuren erläutert. Es zeigen:
- Fig. 1a und 1b: einen Querschnitt und eine Teildarstellung einer ersten Ausführungsform des mikromechanischen Bauteils;
- Fig. 2: eine Teildarstellung einer zweiten Ausführungsform des mikromechanischen Bauteils; und
- Fig. 3: ein Flussdiagramm zum Erläutern einer Ausführungsform des Herstellungsverfahrens für ein mikromechanisches Bauteil.

### Ausführungsformen der Erfindung

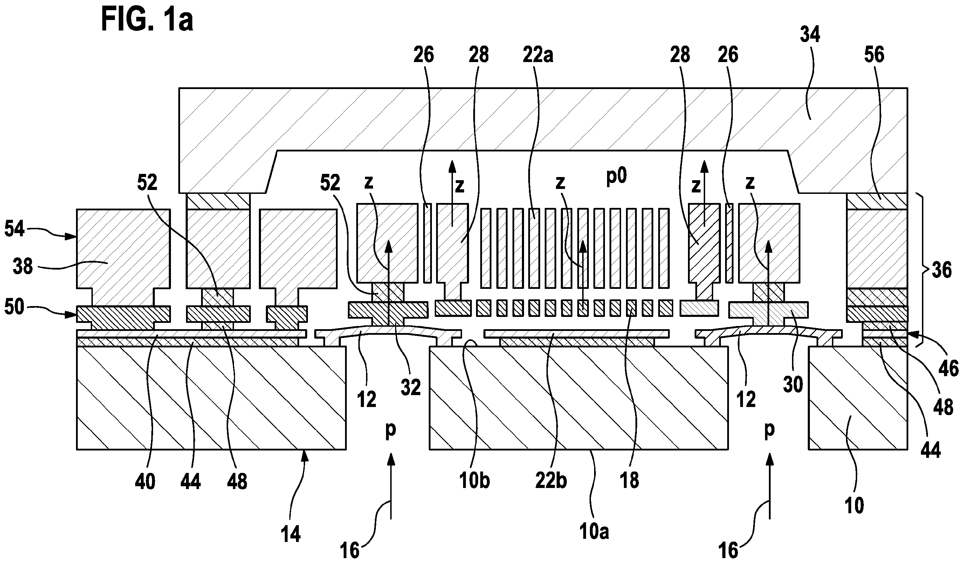

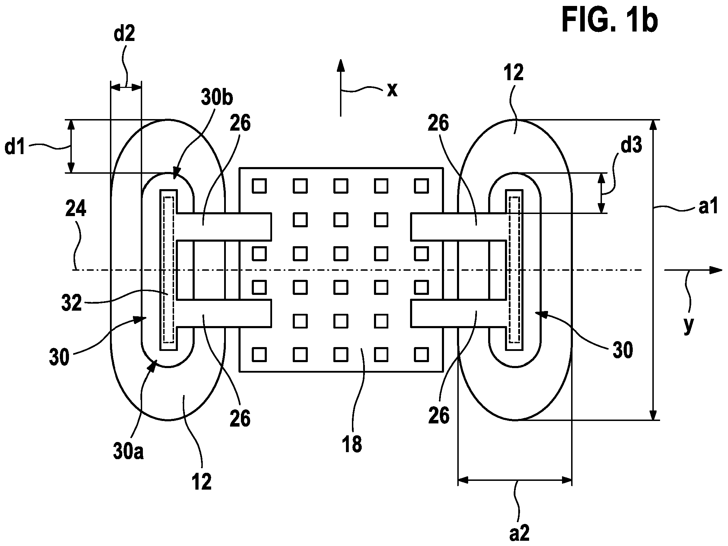

Fig. 1a und 1b zeigen einen Querschnitt und eine Teildarstellung einer ersten Ausführungsform des mikromechanischen Bauteils.

Das in Fig. 1a und 1b schematisch dargestellte mikromechanische Bauteil weist eine Trägerstruktur 10 mit mindestens zwei Membranen 12 (als Teil einer Halterung/eines Gehäuses 14) auf. Beispielhaft ist die Trägerstruktur 10 ein Halbleitersubstrat/ein Halbleiterchip 10 (wie z.B. ein Siliziumsubstrat/ein Siliziumchip 10). Die mindestens zwei Membranen 12 decken je eine sich von einer ersten Seite 10a der Trägerstruktur 10 in die Trägerstruktur 10 erstreckende Aussparung 16 so ab, dass die mindestens zwei Membranen 12 bei einer Druckgleichheit auf der ersten Seite 10a der Trägerstruktur 10 und einer von der ersten Seite 10a weg gerichteten zweiten Seite 10b der Trägerstruktur 10 in einer von einer ersten Raumrichtung x und einer senkrecht zu der ersten Raumrichtung x ausgerichteten zweiten Raumrichtung y aufgespannten Ebene vorliegen. Außerdem sind die mindestens zwei Membranen 12 mittels eines Druckunterschieds zwischen der ersten Seite 10a der Trägerstruktur 10 und der zweiten Seite 10b der Trägerstruktur 10 (aus der von der ersten Raumrichtung x und der zweiten Raumrichtung y aufgespannten Ebene heraus) verwölbbar.

Die mindestens zwei Membranen 12 können beispielsweise ein Außenvolumen der Halterung/des Gehäuses 14 (bzw. des mikromechanischen Bauteils) mit einem darin vorliegenden Druck p auf der ersten Seite 10a der Trägerstruktur 10 von einem Innenvolumen der Halterung/des Gehäuses 14 (bzw. des mikromechanischen Bauteils) mit einem darin vorliegenden Referenzdruck p0 (z.B. nahezu Vakuum) auf der zweiten Seite 10b der Trägerstruktur 10 abgrenzen. Bei einer Druckgleichheit auf beiden Seiten 10a und 10b der Trägerstruktur 10, z.B. wenn der Druck p im Außenvolumen gleich dem Referenzdruck p0 im Innenvolumen ist, liegen die mindestens zwei Membranen 12 in ihrer jeweiligen Ausgangsform vor. Demgegenüber sind die mindestens zwei Membranen 12 mittels des Druckunterschieds zwischen den Seiten 10a und 10b der Trägerstruktur 10, z.B. wenn der Druck p im Außenvolumen von dem Referenzdruck p0 im Innenvolumen abweicht, aus ihrer jeweiligen Ausgangsform verwölbbar. Unter einer mittels des Druckunterschieds induzierten Verwölbung der mindestens zwei Membranen 12 können eine Einwölbung der mindestens zwei Membranen 12 in das Innenvolumen der Halterung/des Gehäuses 14 und/oder eine Auswölbung der mindestens zwei Membranen 12 aus dem Innenvolumen der Halterung/des Gehäuses 14 heraus verstanden werden.

Das mikromechanische Bauteil hat auch mindestens eine Aktorelektrode 18, welche mit den mindestens zwei Membranen 12 derart verbunden ist, dass die mindestens eine Aktorelektrode 18 mittels der Verwölbung der mindestens zwei Membranen 12 aus ihrer jeweiligen Ausgangsstellung verstellbar ist/verstellt wird. Außerdem ist jede der mindestens zwei Membranen 12 mit einer gleichen ersten Ausdehnung a1 in der ersten Raumrichtung x und einer gleichen zweiten Ausdehnung a2 in der zweiten Raumrichtung y ausgebildet, wobei die erste Ausdehnung a1 der mindestens zwei Membranen 12 um zumindest einen Faktor von 1,25 größer als die zweite Ausdehnung a2 der mindestens zwei Membranen 12 ist (siehe Fig. 1b). Im Vergleich mit herkömmlichen ovalen oder länglichen Vergleichsmembranen ist eine mittels der mindestens zwei verwölbten Membranen 12 auf die mindestens eine Aktorelektrode 18 übertragene Kraft genauer ausgerichtet, so dass die mindestens eine Aktorelektrode 18 mittels der mindestens zwei verwölbten Membranen 12 in eine stabilere und gleichmäßigere Bewegung aus ihrer jeweiligen Ausgangsstellung versetzbar ist. Wie in Fig. 1b zusätzlich erkennbar ist, erleichtert eine Ausbildung der mindestens zwei Membranen 12 jeweils mit der gleichen ersten Ausdehnung a1 in der ersten Raumrichtung x und der gleichen zweiten Ausdehnung a2 in der zweiten Raumrichtung y, wobei die erste Ausdehnung a1 um zumindest einen Faktor von 1,25 größer als die zweite Ausdehnung a2 ist, auch eine Minimierung des mikromechanischen Bauteils in der zweiten Raumrichtung y.

Vorzugsweise ist die erste Ausdehnung a1 der mindestens zwei Membranen 12 in der ersten Raumrichtung x um zumindest einen Faktor von 1,5 größer als die zweite Ausdehnung a2 der zumindest zwei Membranen 12 in der zweiten Raumrichtung y. Insbesondere kann die erste Ausdehnung a1 der mindestens zwei Membranen 12 in der ersten Raumrichtung x um zumindest einen Faktor von 2 größer als die zweite Ausdehnung a2 der zumindest zwei Membranen 12 in der zweiten Raumrichtung y sein. Dies verbessert eine Einhaltbarkeit der gewünschten stabilen und gleichmäßigen Bewegung der mindestens einen Aktorelektrode 18 und erleichtert zusätzlich eine Minimierung des mikromechanischen Bauteils in der zweiten Raumrichtung y.
Eine Membrandicke/Schichtdicke der Membranen 12 (senkrecht zu der ersten Raumrichtung x und senkrecht zu der zweiten Raumrichtung y) kann ebenfalls gleich sein.

In der hier beschriebenen Ausführungsform weist das mikromechanische Bauteil zusätzlich mindestens eine Statorelektrode 22a und 22b auf, welche derart an der Halterung/dem Gehäuse 14 und/oder in Bezug zu der Halterung/dem Gehäuse 14 angeordnet ist, dass bei einer Verwölbung der Membranen 12 eine Relativbewegung der mindestens einen Statorelektrode 22a und 22b in Bezug zu der Halterung/dem Gehäuse 14 unterbunden ist. Vorteilhafterweise ist die mindestens eine Statorelektrode 22a und 22/dem Gehäuse 14 auf einer zu den Membranen 12 ausgerichteten Seite der mindestens einen Aktorelektrode 18 und/oder auf einer von den Membranen 12 weg gerichteten Seite der mindestens einen Aktorelektrode 18 angeordnet.

Außerdem ist die mindestens eine Aktorelektrode 18 mittels der Verwölbung der Membranen 12 aus ihrer jeweiligen Ausgangsstellung entlang einer senkrecht zu der ersten Raumrichtung x und senkrecht zu der zweiten Raumrichtung y ausgerichteten dritten Raumrichtung z verstellbar. Die mindestens eine Aktorelektrode 18 kann somit mittels der Verwölbung der Membranen 12 (entlang der dritten Raumrichtung z) direkt auf die mindestens eine (auf ihrer von den Membranen 12 weg gerichteten Seite angeordnete) Statorelektrode 22a zubewegt werden und/oder direkt von der mindestens einen (auf ihrer zu den Membranen 12 ausgerichteten Seite angeordneten) Statorelektrode 22b weg bewegt werden. Mittels der Verwölbung der Membran 12 kann somit eine signifikante Kapazitätsänderung mindestens einer Kapazität zwischen der mindestens einen Aktorelektrode 18 und der mindestens einen zugeordneten Statorelektrode 22a und 22b bewirkt werden. Dies kann zum genauen, verlässlichen und fehlerfreien Nachweisen/Messen des Druckunterschieds zwischen der ersten Seite 10a und der zweiten Seite 10b, d.h. zwischen dem Druck p und dem Referenzdruck p0, genutzt werden.

Die Ausführungsform der Fig. 1a und 1b weist als die mindestens eine Statorelektrode 22a und 22b mindestens eine über dem Halbleitersubstrat 14 aufgehängte (freistehende) Statorelektrode 22a auf der von den Membranen 12 weg gerichteten Seite der mindestens einen Aktorelektrode 18 und mindestens eine an dem Halbleitersubstrat 14 angebundene Statorelektrode 22b auf der zu den Membranen 12 ausgerichteten Seite der mindestens einen Aktorelektrode 18 auf. Alternativ kann die mindestens eine Statorelektrode 22b auf der zu den Membranen 12 ausgerichteten Seite der mindestens einen Aktorelektrode 18 auch als freistehende Elektrode ausgeführt sein.

Die Ausführungsform der Fig. 1a und 1b nutzt die vorteilhafte Form der Membranen 12 (jeweils mit der gleichen ersten Ausdehnung a1 in der ersten Raumrichtung x um zumindest den Faktor von 1,25 größer als die zweite Ausdehnung a2 in der zweiten Raumrichtung y) zur Minimierung ihrer Membrananzahl. Während herkömmlicherweise membranbestückte Sensorvorrichtungen zumindest drei runde oder quadratische Vergleichsmembranen benötigen, um eine senkrecht zu den Vergleichsmembranen ausgerichtete und verkippfreie Bewegung der mindestens einen daran angebundenen beweglichen Elektrode mittels der verwölbten Vergleichsmembranen zu bewirken, weist das mikromechanische Bauteil der Fig. 1a und 1b genau/nur eine erste Membran 12 und eine zweite Membran 12 als die mindestens zwei Membranen 12 auf. Dies erleichtert eine Minimierung des mikromechanischen Bauteils gegenüber den herkömmlichen membranbestückten Sensorvorrichtungen und steigert zusätzlich eine Kompaktheit seines Designs. Trotz der Realisierung der vorteilhaften Verstellbarkeit der mindestens einen Aktorelektrode 18 in die dritte Raumrichtung z kann damit die Trägerstruktur/das Halbleitersubstrat 10 mit den lediglich zwei Membranen 12 kleinflächig ausgebildet werden. Das mikromechanische Bauteil der Fig. 1a und 1b weist somit ein flächensparendes Design auf, und ist gleichzeitig robust gegenüber einer Kippbewegung der mindestens einen Aktorelektrode 18. Das in Fig. 1a und 1b schematisch dargestellte mikromechanische Bauteil kann aufgrund der Verkippfreiheit seiner mindestens einen Aktorelektrode 18 vergleichsweise klein und leicht ausgeführt werden. Trotzdem ermöglicht selbst eine minimierte Ausbildung des mikromechanischen Bauteils dessen verlässliche Verwendbarkeit.

Außerdem weist das mikromechanische Bauteil der Fig. 1a und 1b genau/nur eine einzige Aktorelektrode 18 als die mindestens eine Aktorelektrode auf. Die erste Membran 12 ist auf einer ersten Seite der Aktorelektrode 18 angeordnet. Die zweite Membran 12 ist auf einer von der ersten Seite weg gerichteten zweiten Seite der Aktorelektrode 18 angeordnet. Eine senkrecht zu der ersten Raumrichtung x ausgerichtete Ebene 24 schneidet die Aktorelektrode 18 und die zwei Membranen 12 mittig. Die Aktorelektrode 18 und die zwei Membranen 12 können insbesondere spiegelsymmetrisch bezüglich der Ebene 24 ausgebildet sein. Dies trägt zum zusätzlichen Reduzieren eines Risikos eines Verkippens der Aktorelektrode 18 beim Ausführen ihrer durch die verwölbten Membranen 12 ausgelösten Bewegung entlang der dritten Raumrichtung z bei.

Jede der zwei Membranen 12 ist über mindestens ein Stegelement 26 mit der Aktorelektrode 18 verbunden. Außerdem ist die Aktorelektrode 18 in einem Aktorelektrodenrahmen 28 eingesetzt, welcher über die mindestens zwei Stegelemente 26 mit den Membranen 12 verbunden ist. Als vorteilhafte Weiterbildung sind die zwei Membranen 12 zusätzlich mit je einem sich in die erste Raumrichtung x erstreckenden Versteifungssteg 30 ausgebildet. Jeder der zwei Versteifungsstege 30 kann seine zugeordnete Membran 12 in der zweiten Raumrichtung y mittig schneiden. Die Ausbildung der Versteifungsstege 30 an den Membranen 12 trägt somit dazu bei, unerwünschte Verkippkräfte in die zweite Raumrichtung y von der Aktorelektrode 18 abzuhalten. Es ist auch vorteilhaft, wenn jeweils ein erster Endabschnitt 30a der zwei Versteifungsstege 30, von welchem aus sich der jeweilige Versteifungssteg 30 entlang der ersten Raumrichtung x zu einem zweiten Endabschnitt 30b des gleichen Versteifungsstegs 30 erstreckt, einen gleichen Abstand zu einem Rand seiner Membran 12 aufweist wie der zweite Endabschnitt 30b. Somit müssen bei einer Verwölbung der Membranen 12 auch keine unerwünschten Auslenkkräfte in die erste Raumrichtung x befürchtet werden.

Bevorzugter Weise weist auch jeder der zwei Versteifungsstege 30 einen ersten maximalen Abstand d1 in der ersten Raumrichtung x zu dem Rand der Membran 12 auf, welcher um zumindest einen Faktor zwischen 1,1 und 2,5 größer als ein zweiter maximaler Abstand d2 des gleichen Versteifungsstegs 30 in der zweiten Raumrichtung y zu dem Rand seiner Membran 12 ist. Dies gewährleistet eine gute Verformbarkeit der Membranen 12 so, dass die Aktorelektrode 18 verkippfrei in die dritte Raumrichtung z verstellt wird.

Die Stegelemente 26 erstrecken sich jeweils von dem zugeordneten Versteifungssteg 30 zu dem Aktorelektrodenrahmen 28. Vorteilhafterweise ist bei der Ausführungsform der Fig. 1a und 1b jeder Versteifungssteg 30 über je zwei Stegelemente 26 mit dem Aktorelektrodenrahmen 28 verbunden, wobei die jeweiligen zwei Stegelemente 26 bezüglich der Ebene 24 spiegelsymmetrisch ausgebildet sind. Dies reduziert zusätzlich ein Verkippungsrisiko der Bewegung der Aktorelektrode 18 in die dritte Raumrichtung z bei einer Verwölbung der Membranen 12. Es ist auch günstig, die Stegelemente 26 mit einem (dritten) Abstand d3 (ungleich Null) zum benachbarten Endabschnitt 30a oder 30b des kontaktierten Versteifungsstegs 30 an dem jeweiligen Versteifungssteg 30 zu verankern. Vorteilhaft ist es auch, wenn die Versteifungsstege 30 an ihren Endabschnitten 30a und 30b, insbesondere ausgehend von ihren Endabschnitten 30a und 30b bis zu den Verankerungsbereichen der Stegelemente 26, etwas weicher/dünner ausgebildet sind (als an und zwischen den Verankerungsbereichen der Stegelemente 26).

In der Ausführungsform der Fig. 1a und 1b sind die Versteifungsstege 30 zusätzlich mit je einem Sockelabschnitt 32(an ihren zu der zugeordneten Membran 12 ausgerichteten Seiten) ausgebildet, wobei die Versteifungsstege 30 (ausschließlich) an ihren Sockelabschnitten 32 an der zugeordneten Membran 12 verankert sind. Dies steigert eine Sensitivität/Empfindlichkeit der Membranen 12 auf einen Druckunterschied zwischen der ersten Seite 10a der Trägerstruktur 10 und der zweiten Seite 10b der Trägerstruktur 10 zusätzlich.

Beispielhaft umfasst die Halterung/das Gehäuse 14 des mikromechanischen Bauteils auch einen Kappenwafer 34, welcher an einem an dem Halbleitersubstrat 14 befestigten Rahmen 36 festgebondet ist. Außerdem weist das mikromechanische Bauteil auch einen außerhalb des Kappenwafers 34 ausgebildeten Kontakt 38 auf, welcher an mindestens einer durch den Rahmen 36 führenden Leiterbahn 40 elektrisch angebunden ist. Bezüglich weiterer Eigenschaften des mikromechanischen Bauteils wird auf das unten erläuterte Herstellungsverfahren verwiesen.

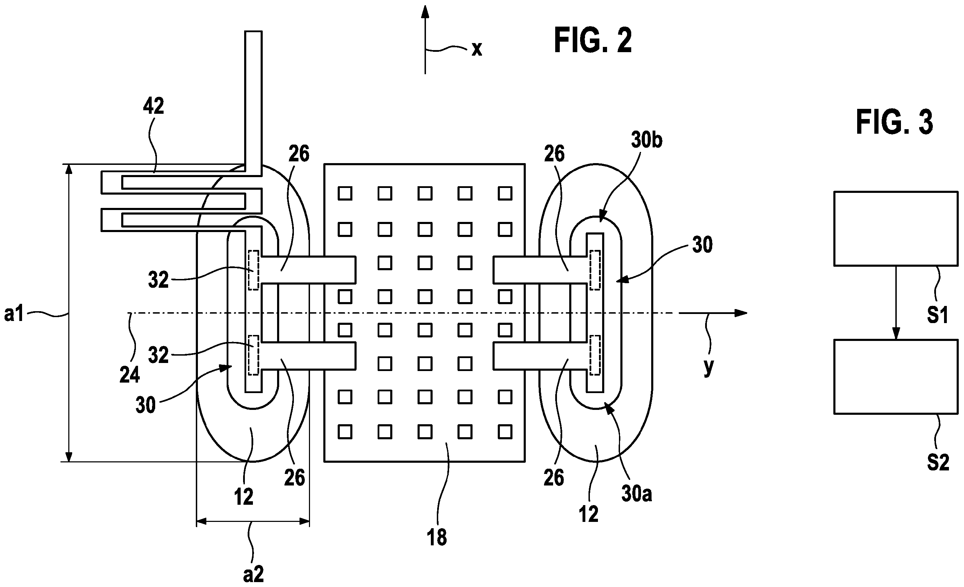

Fig. 2 zeigt eine Teildarstellung einer zweiten Ausführungsform des mikromechanischen Bauteils.

Das in Fig. 2 schematisch dargestellte mikromechanische Bauteil weist die Merkmale der zuvor erläuterten Ausführungsform auf. Als Ergänzung hat das mikromechanische Bauteil noch mindestens ein Federelement 42, über welches mindestens einer der zwei Versteifungsstege mit der Trägerstruktur 10 verbunden ist. Das mindestens eine Federelement 42 überspannt jeweils die Membran 12 des zugeordneten Versteifungsstegs 30 teilweise. Das mindestens eine Federelement 42 kann zum elektrischen Anschluss der Aktorelektrode 18 genutzt werden. Da die Membranen 12 aufgrund ihrer vorteilhaften Membranform deutlich steifer ausgelegt sein können, kann ein günstiges Verhältnis zwischen der Steifigkeit der Membranen 12 und der Steifigkeit des mindestens einen Federelements 42 erreicht werden. Somit ist nicht zu befürchten, dass das mindestens eine Federelement 42 eine Verwölbung der Membranen 12 oder eine mittels der verwölbten Membranen 12 bewirkte Bewegung der Aktorelektrode 18 in die dritte Raumrichtung z signifikant beeinflusst. Vorzugsweise überspannt das mindestens eine Federelement 42 seine zugeordnete Membran 12 in Richtung der ersten Raumrichtung x.
(In der ersten Raumrichtung x weisen die Membranen 12 eine besonders hohe Steifigkeit auf.)

In der Ausführungsform der Fig. 2 sind außerdem zwei Sockelabschnitten 32 pro Versteifungssteg 30 (an ihren zu der zugeordneten Membran 12 ausgerichteten Seiten) ausgebildet. Die Kontaktbereiche zwischen jedem der Versteifungsstege 30 und seiner zugeordneten Membran 12 sind somit auf die je zwei Sockelabschnitte 32 pro Versteifungssteg 30 beschränkt.

Die oben beschriebenen mikromechanischen Bauteile können z.B. in einem Mikrofon oder in einem Drucksensor vorteilhaft eingesetzt werden. Ein derartiger Drucksensor umfasst vorzugsweise auch eine (nicht dargestellte) Auswerteeinrichtung, welche dazu ausgelegt ist, unter Berücksichtigung mindestens eines Signals bezüglich mindestens einer zwischen der mindestens Aktorelektrode 18 und der mindestens einen Statorelektrode 22a und 22b vorliegenden Kapazität einen Ausgabewert bezüglich des Druckunterschieds zwischen der ersten Seite 10a der Trägerstruktur 10 und der zweiten Seite 10b der Trägerstruktur 10 festzulegen und auszugeben. Aufgrund der vergleichsweise großen Kapazitätsänderung, welche mittels der durch die verwölbten Membranen 12 ausgelösten Bewegung der Aktorelektrode 18 in die dritte Raumrichtung z erreichbar ist, kann die Auswerteeinrichtung vergleichsweise kostengünstig ausgebildet sein. Der jeweilige Drucksensor kann auch als Teil einer Sensorvorrichtung mit einem anderen Sensortyp, beispielsweise zusammen mit einem Beschleunigungs-, Drehraten- und/oder Magnetfeldsensor, ausgebildet sein.

Fig. 3 zeigt ein Flussdiagramm zum Erläutern einer Ausführungsform des Herstellungsverfahrens für ein mikromechanisches Bauteil.

In einem Verfahrensschritt S1 werden mindestens zwei Membranen, welche je eine sich von einer ersten Seite einer Trägerstruktur in die Trägerstruktur erstreckende Aussparung abdecken, so ausgebildet, dass die mindestens zwei Membranen bei einer Druckgleichheit auf der ersten Seite der Trägerstruktur und einer von der ersten Seite weg gerichteten zweiten Seite der Trägerstruktur in einer von einer ersten Raumrichtung und einer senkrecht zu der ersten Raumrichtung ausgerichteten zweiten Raumrichtung aufgespannten Ebene vorliegen und mittels eines Druckunterschieds zwischen der ersten Seite der Trägerstruktur und der zweiten Seite der Trägerstruktur verwölbt werden. Außerdem wird jede der mindestens zwei Membranen mit einer gleichen ersten Ausdehnung in der ersten Raumrichtung und einer gleichen zweiten Ausdehnung in der zweiten Raumrichtung ausgebildet, wobei die erste Ausdehnung um zumindest einen Faktor von 1,25 größer als die zweite Ausdehnung ausgebildet wird.

In einem weiteren Verfahrensschritt S2 wird mindestens eine Aktorelektrode so mit den mindestens zwei Membranen verbunden, dass die mindestens eine Aktorelektrode mittels einer Verwölbung der mindestens zwei Membranen aus ihrer jeweiligen Ausgangsstellung verstellt wird. Der Verfahrensschritt S2 kann vor, nach oder zeitlich überlappend mit dem Verfahrensschritt S2 ausgeführt werden.

Als Ausgangsmaterial zum Ausführen der Verfahrensschritte S1 und S2 kann ein Schichtaufbau verwendet werden, wie er in Fig. 1a restweise zu erkennen ist: Auf dem Halbleitersubstrat 10 wird (vor oder nach dem Strukturieren der Aussparungen 16) zuerst eine erste Isolierschicht 44, wie z.B. eine Siliziumdioxidschicht, gebildet. Dann wird eine erste Halbleiterschicht 46, insbesondere eine dünne Polysilizium-Schicht, auf der ersten Isolierschicht 44 gebildet. Aus der ersten Halbleiterschicht 46 können (später) die Membranen 12, die mindestens eine Statorelektrode 22b, die mindestens eine Leiterbahn 40 und Teile des Rahmens 36 heraus strukturiert werden. Die erste Halbleiterschicht 46 wird zumindest teilweise mit einer zweiten Isolierschicht 48, wie z.B. einer Siliziumdioxidschicht, abgedeckt. Auf der zweiten Isolierschicht 48 wird eine zweite Halbleiterschicht 50, vorzugsweise eine mittlere polykristalline Siliziumschicht, abgeschieden. Aus der zweiten Halbleiterschicht 50 werden später die mindestens eine Aktorelektrode 18, die Versteifungsstege 30, evtl. das mindestens eine Federelement 42, Teile des Rahmens 36 und ein Teil des Kontakts 38 heraus strukturiert. Eine dritte Isolierschicht 52 (z.B. eine Siliziumdioxidschicht) deckt die zweite Halbleiterschicht 50 zumindest teilweise ab. Anschließend wird eine dritte Halbleiterschicht 54, vorzugsweise eine dicke Epi-Polysiliziumschicht, auf der dritten Isolierschicht 52 abgeschieden. Aus der dritten Halbleiterschicht 54 werden (später) die mindestens eine Statorelektrode 22a, die Stegelemente 26, der Aktorelektrodenrahmen 28, Teile des Rahmens 36 und ein Teil des Kontakts 38 heraus strukturiert.

Nach einem Ausführen mindestens eines Ätzprozesses zum Strukturieren des Schichtaufbaus kann noch der Kappenwafer 34 über eine Bondverbindung 56 hermetisch an den Rahmen 36 gebondet werden. Der Kappenwafer 34 dient einerseits als Schutz für die empfindlichen Strukturen, andererseits kann mittels des Bondverfahrens ein definierter Druck als Referenzdruck p0 in dem Innenvolumen eingestellt werden.

## Patentansprüche

1. Mikromechanisches Bauteil mit:
einer Trägerstruktur (10) mit mindestens zwei Membranen (12), wobei die mindestens zwei Membranen (12) je eine sich von einer ersten Seite (10a) der Trägerstruktur (10) in die Trägerstruktur (10) erstreckende Aussparung (16) so abdecken, dass die mindestens zwei Membranen (12) bei einer Druckgleichheit auf der ersten Seite (10a) der Trägerstruktur (10) und einer von der ersten Seite (10a) weg gerichteten zweiten Seite (10b) der Trägerstruktur (10) in einer von einer ersten Raumrichtung (x) und einer senkrecht zu der ersten Raumrichtung (x) ausgerichteten zweiten Raumrichtung (y) aufgespannten Ebene vorliegen und mittels eines Druckunterschieds zwischen der ersten Seite (10a) der Trägerstruktur (10) und der zweiten Seite (10b) der Trägerstruktur (10) verwölbbar sind; und
mindestens einer Aktorelektrode (18), welche mit den mindestens zwei Membranen (12) derart verbunden ist, dass die mindestens eine Aktorelektrode (18) mittels einer Verwölbung der mindestens zwei Membranen (12) aus ihrer jeweiligen Ausgangsstellung verstellbar ist;
**dadurch gekennzeichnet, dass**
jede der mindestens zwei Membranen (12) mit einer gleichen ersten Ausdehnung (a1) in der ersten Raumrichtung (x) und einer gleichen zweiten Ausdehnung (a2) in der zweiten Raumrichtung (y) ausgebildet ist, wobei die erste Ausdehnung (a1) um zumindest einen Faktor von 1,25 größer als die zweite Ausdehnung (a2) ist.

2. Mikromechanisches Bauteil nach Anspruch 1, wobei die erste Ausdehnung (a1) um zumindest einen Faktor von 2 größer als die zweite Ausdehnung (a2) ist.

3. Mikromechanisches Bauteil nach Anspruch 1 oder 2 , wobei die mindestens eine Aktorelektrode (18) mittels der Verwölbung der Membranen (12) aus ihrer jeweiligen Ausgangsstellung entlang einer senkrecht zu der ersten Raumrichtung (x) und senkrecht zu der zweiten Raumrichtung (y) ausgerichteten dritten Raumrichtung (z) verstellbar ist.

4. Mikromechanisches Bauteil nach einem der vorhergehenden Ansprüche, wobei das mikromechanische Bauteil genau eine erste Membran (12) und eine zweite Membran (12) als die mindestens zwei Membranen (12) aufweist.

5. Mikromechanisches Bauteil nach Anspruch 4, wobei das mikromechanische Bauteil genau eine einzige Aktorelektrode (18) als die mindestens eine Aktorelektrode (18) aufweist, und wobei die erste Membran (12) auf einer ersten Seite der Aktorelektrode (18) und die zweite Membran (12) auf einer von der ersten Seite weg gerichteten zweiten Seite der Aktorelektrode (18) angeordnet sind.

6. Mikromechanisches Bauteil nach Anspruch 5, wobei eine senkrecht zu der ersten Raumrichtung (x) ausgerichtete Ebene (24) die Aktorelektrode (18) und die zwei Membranen (12) mittig schneidet.

7. Mikromechanisches Bauteil nach einem der Ansprüche 4 bis 6, wobei die zwei Membranen (12) mit je einem sich in die erste Raumrichtung (x) erstreckenden Versteifungssteg (30) ausgebildet sind.

8. Mikromechanisches Bauteil nach Anspruch 7, wobei jeder der zwei Versteifungsstege (30) einen ersten maximalen Abstand (d1) in der ersten Raumrichtung (x) zu einem Rand seiner Membran (12) aufweist, welcher um einen Faktor zwischen 1,1 und 2,5 größer ist als ein zweiter maximaler Abstand (d2) des gleichen Versteifungsstegs (30) in der zweiten Raumrichtung (y) zu dem Rand seiner Membran (12).

9. Mikromechanisches Bauteil nach Anspruch 7 oder 8, wobei mindestens einer der zwei Versteifungsstege (30) über mindestens ein seine Membran teilweise überspannendes Federelement (42) mit der Trägerstruktur (10) verbunden ist.

10. Mikrophon mit einem mikromechanischen Bauteil nach einem der vorhergehenden Ansprüche.

11. Drucksensor mit einem mikromechanischen Bauteil nach einem der Ansprüche 1 bis 9.

12. Herstellungsverfahren für ein mikromechanisches Bauteil mit den Schritten:
Ausbilden von mindestens zwei Membranen (12), welche je eine sich von einer ersten Seite (10a) einer Trägerstruktur (10) in die Trägerstruktur (10) erstreckende Aussparung (16) so abdecken, dass die mindestens zwei Membranen (12) bei einer Druckgleichheit auf der ersten Seite (10a) der Trägerstruktur (10) und einer von der ersten Seite (10a) weg gerichteten zweiten Seite (10b) der Trägerstruktur (10) in einer von einer ersten Raumrichtung (x) und einer senkrecht zu der ersten Raumrichtung (x) ausgerichteten zweiten Raumrichtung (y) aufgespannten Ebene vorliegen und mittels eines Druckunterschieds zwischen der ersten Seite (10a) der Trägerstruktur (10) und der zweiten Seite (10b) der Trägerstruktur (10) verwölbt werden; und
Verbinden mindestens einer Aktorelektrode (18) so mit den mindestens zwei Membranen (12), dass die mindestens eine Aktorelektrode (18) mittels einer Verwölbung der mindestens zwei Membranen (12) aus ihrer jeweiligen Ausgangsstellung verstellt wird (S2);
**dadurch gekennzeichnet, dass**
jede der mindestens zwei Membranen (12) mit einer gleichen ersten Ausdehnung (a1) in der ersten Raumrichtung (x) und einer gleichen zweiten Ausdehnung (a2) in der zweiten Raumrichtung (y) ausgebildet wird, wobei die erste Ausdehnung (a1) um zumindest einen Faktor von 1,25 größer als die zweite Ausdehnung (a2) ausgebildet wird (S1).

## Claims

1. Micromechanical component, comprising:
a carrier structure (10) with at least two membranes (12), wherein the at least two membranes (12) each cover a cutout (16), which extends from a first side (10a) of the carrier structure (10) into the carrier structure (10), such that, in the case of a pressure equality on the first side (10a) of the carrier structure (10) and a second side (10b) of the carrier structure (10) that is directed away from the first side (10a), the at least two membranes (12) are present in a plane which is defined by a first spatial direction (x) and a second spatial direction (y) which is oriented perpendicularly to the first spatial direction (x) and can be bent by means of a pressure difference between the first side (10a) of the carrier structure (10) and the second side (10b) of the carrier structure (10); and
at least one actuator electrode (18) which is connected to the at least two membranes (12) in such a way that the at least one actuator electrode (18) can be adjusted by means of bending of the at least two membranes (12) out of their respective initial position;
**characterized in that**
each of the at least two membranes (12) is formed with the same first extent (a1) in the first spatial direction (x) and the same second extent (a2) in the second spatial direction (y), wherein the first extent (a1) is greater by at least a factor of 1.25 than the second extent (a2).

2. Micromechanical component according to Claim 1, wherein the first extent (a1) is greater by at least a factor of 2 than the second extent (a2).

3. Micromechanical component according to Claim 1 or 2, wherein the at least one actuator electrode (18) can be adjusted by means of the bending of the membranes (12) out of their respective initial position along a third spatial direction (z) which is oriented perpendicularly to the first spatial direction (x) and perpendicularly to the second spatial direction (y).

4. Micromechanical component according to one of the preceding claims, wherein the micromechanical component has precisely one first membrane (12) and one second membrane (12) as the at least two membranes (12).

5. Micromechanical component according to Claim 4, wherein the micromechanical component has precisely one single actuator electrode (18) as the at least one actuator electrode (18), and wherein the at least one membrane (12) is arranged on a first side of the actuator electrode (18) and the second membrane (12) is arranged on a second side of the actuator electrode (18) that is directed away from the first side.

6. Micromechanical component according to Claim 5, wherein a plane (24) which is oriented perpendicularly to the first spatial direction (x) centrally intersects the actuator electrode (18) and the two membranes (12).

7. Micromechanical component according to one of Claims 4 to 6, wherein the two membranes (12) are each designed with a reinforcing web (30) which extends in the first spatial direction (x).

8. Micromechanical component according to Claim 7, wherein each of the two reinforcing webs (30) is at a first maximum distance (d1) in the first spatial direction (x) from an edge of its membrane (12), which distance is greater by a factor of between 1.1 and 2.5 than a second maximum distance (d2) of the same reinforcing web (30) in the second spatial direction (y) from the edge of its membrane (12).

9. Micromechanical component according to Claim 7 or 8, wherein at least one of the two reinforcing webs (30) is connected to the carrier structure (10) by means of at least one spring element (42) which partially spans its membrane.

10. Microphone comprising a micromechanical component according to one of the preceding claims.

11. Pressure sensor comprising a micromechanical component according to one of Claims 1 to 9.

12. Production method for a micromechanical component, comprising the steps of:
forming at least two membranes (12) which each cover a cutout (16), which extends from a first side (10a) of a carrier structure (10) into the carrier structure (10), such that, in the case of a pressure equality on the first side (10a) of the carrier structure (10) and a second side (10b) of the carrier structure (10) that is directed away from the first side (10a), the at least two membranes (12) are present in a plane which is defined by a first spatial direction (x) and a second spatial direction (y) which is oriented perpendicularly to the first spatial direction (x) and are bent by means of a pressure difference between the first side (10a) of the carrier structure (10) and the second side (10b) of the carrier structure (10); and
connecting at least one actuator electrode (18) to the at least two membranes (12) such that the at least one actuator electrode (18) is adjusted (S2) by means of bending of the at least two membranes (12) out of their respective initial position;
**characterized in that**
each of the at least two membranes (12) is formed with the same first extent (a1) in the first spatial direction (x) and the same second extent (a2) in the second spatial direction (y), wherein the first extent (a1) is formed (S1) to be greater by at least a factor of 1.25 than the second extent (a2).

## Revendications

1. Composant micromécanique comprenant :
une structure porteuse (10) munie d'au moins deux membranes (12), les au moins deux membranes (12) recouvrant chacune un évidement (16) qui s'étend d'un premier côté (10a) de la structure porteuse (10) jusque dans la structure porteuse (10) de sorte que, lorsque la pression est égale sur le premier côté (10a) de la structure porteuse (10) et sur un deuxième côté (10b) de la structure porteuse (10) qui est dirigé à l'opposé du premier côté (10a), les au moins deux membranes (12) soient situées dans un plan passant par une première direction spatiale (x) et une deuxième direction spatiale (y) orientée perpendiculairement à la première direction spatiale (x) et puissent être incurvées à l'aide d'une différence de pression entre le premier côté (10a) de la structure porteuse (10) et le deuxième côté (10b) de la structure porteuse (10) ; et
au moins une électrode d'actionnement (18) qui est reliée aux au moins deux membranes (12) de telle sorte que l'au moins une électrode d'actionnement (18) puisse être ajustée par incurvation des au moins deux membranes (12) depuis leur position initiale respective ;
**caractérisé en ce que**
chacune des au moins deux membranes (12) est conçue avec une même première dimension (a1) dans la première direction spatiale (x) et une même deuxième dimension (a2) dans la deuxième direction spatiale (y), la première dimension (a1) étant supérieure à la deuxième dimension (a2) d'au moins un facteur 1,25.

2. Composant micromécanique selon la revendication 1, la première dimension (a1) étant supérieure à la deuxième dimension (a2) d'au moins un facteur de 2.

3. Composant micromécanique selon la revendication 1 ou 2, l'au moins une électrode d'actionnement (18) étant réglable depuis sa position initiale respective le long d'une troisième direction spatiale (z) perpendiculaire à la première direction spatiale (x) et perpendiculaire à la deuxième direction spatiale (y) par incurvation des membranes (12).

4. Composant micromécanique selon l'une des revendications précédentes, les au moins deux membranes (12) que comporte le composant micromécanique étant exactement une première membrane (12) et une deuxième membrane (12).

5. Composant micromécanique selon la revendication 4, l'au moins une électrode d'actionnement (18) que comporte le composant micromécanique étant exactement une seule électrode d'actionnement (18), et la première membrane (12) étant disposée sur un premier côté de l'électrode d'actionnement (18) et la deuxième membrane (12) étant disposée sur un deuxième côté de l'électrode d'actionnement (18) dirigé à l'opposé du premier côté.

6. Composant micromécanique selon la revendication 5, un plan (24) orienté perpendiculairement à la première direction spatiale (x) coupant l'électrode d'actionnement (18) et les deux membranes (12) au milieu.

7. Composant micromécanique selon l'une des revendications 4 à 6, les deux membranes (12) étant chacune formées avec une nervure de rigidification (30) qui s'étend dans la première direction spatiale (x).

8. Composant micromécanique selon la revendication 7, chacune des deux nervures de rigidification (30) étant à une première distance maximale (d1) dans la première direction spatiale (x) par rapport à un bord de sa membrane (12), laquelle distance est supérieure, d'un facteur compris entre 1,1 et 2,5, à une deuxième distance maximale (d2) de la même nervure de rigidification (30), dans la deuxième direction spatiale (y), par rapport au bord de sa membrane (12).

9. Composant micromécanique selon la revendication 7 ou 8, l'une au moins des deux nervures de rigidification (30) étant reliée à la structure porteuse (10) par le biais d'au moins un élément à ressort (42) qui couvre partiellement sa membrane.

10. Microphone comprenant un composant micromécanique selon l'une des revendications précédentes.

11. Capteur de pression comprenant un composant micromécanique selon l'une des revendications 1 à 9.

12. Procédé de fabrication d'un composant micromécanique, ledit procédé comprenant les étapes suivantes :
former au moins deux membranes (12) qui recouvrent chacune un évidement (16) qui s'étend d'un premier côté (10a) d'une structure porteuse (10) jusque dans la structure porteuse (10) de sorte que, lorsque la pression est égale sur le premier côté (10a) de la structure porteuse (10) et sur un deuxième côté (10b) de la structure porteuse (10) qui est dirigé à l'opposé du premier côté (10a), les au moins deux membranes (12) soient situées dans un plan passant par une première direction spatiale (x) et une deuxième direction spatiale (y) orientée perpendiculairement à la première direction spatiale (x) et puissent être incurvées à l'aide d'une différence de pression entre le premier côté (10a) de la structure porteuse (10) et le deuxième côté (10b) de la structure porteuse (10) ; et
relier au moins une électrode d'actionnement (18) aux au moins deux membranes (12) de telle sorte que l'au moins une électrode d'actionnement (18) soit déplacée (S2) par incurvation des au moins deux membranes (12) de leur position initiale respective ;
**caractérisé en ce que**
chacune des au moins deux membranes (12) est formée avec la même première dimension (a1) dans la première direction spatiale (x) et la même deuxième dimension (a2) dans la deuxième direction spatiale (y), la première dimension (a1) étant conçue (S1) pour être supérieure à la deuxième dimension (a2) d'au moins un facteur 1,25.
